# EUROPÄISCHE PATENTANMELDUNG

(11) **EP 0 760 313 A2**
(43) Veröffentlichungstag der Anmeldung: **05.03.1997**
(21) Anmeldenummer: 96109811.8
(22) Anmeldetag: 19.06.1996
(51) Int. Cl.: B60R 16/02

(54) **Zentralelektrik für Kraftfahrzeuge**

(30) Priorität: 28.11.1995 DE 19544235; 25.08.1995 DE 19531537
(71) Anmelder: VDO Adolf Schindling AG, 60326 Frankfurt/Main (DE)
(72) Erfinder: Zintler, Albert, 64521 Gross-Gerau (DE); Busch, Dieter, 61191 Rosbach (DE); Ullrich, Horst, 61137 Schöneck 1 (DE)
(74) Vertreter: Klein, Thomas, Dipl.-Ing. (FH)

(57) **Zusammenfassung**

Die Erfindung betrifft eine Zentralelektrik für Kraftfahrzeuge, bei welcher ein elektrisches Bauteil, über das verschiedene elektrische Leistungsebenen miteinander verbunden werden, auf einem isolierenden Bauteileträger angeordnet ist, wobei die Anschlüsse des elektrischen Bauteils in den isolierenden Bauteileträger eingreifen.

Um eine kompakte und störungsunempfindliche Zentralelektrik für Kraftfahrzeuge zu gewährleisten, wird erfindungsgemäß an der dem Bauteileträger abgewandten Seite des Bauteileträgers mindestens ein mit einer höheren Leistung beanspruchter Anschluß des elektrischen Bauteils mit einer Stromzufuhr kontaktiert, während mindestens ein niedrigbelasteter Anschluß des elektronischen Bauteils mit einem elektronische Bauelemente tragenden, von dem isolierenden Bauteileträger körperlich getrennt angeordneten Trägerkörper verbunden ist.

## Beschreibung

Die Erfindung betrifft eine Zentralelektrik für Kraftfahrzeuge, bei welcher ein elektrisches Bauteil, über das verschiedene elektrische Leistungsebenen miteinander verbunden werden, auf einem isolierenden Bauteileträger angeordnet ist, wobei die Anschlüsse des elektrischen Bauteils in den isolierenden Bauteileträger eingreifen.

Eine solche Zentralelektrik erfüllt im wesentlichen eine Verteilerfunktion, um die elektrischen Verbraucher des Kraftfahrzeugs, wie z. B. Scheibenwischer oder Blinker u.ä., über elektrische Leitungen oder Kabelbäume mit elektrischer Spannung zu versorgen und die Funktionstüchtigkeit der Verbraucher zu überwachen. Die Ansteuerung der elektrischen Verbraucher erfolgt dabei über Schaltgeräte, die auf der Oberseite der Zentralelektrik gemeinsam mit den Sicherungen der Verbraucherstromkreise steckbar angeordnet sind.

Die aufgesteckten Schaltgeräte beinhalten zumeist ein Relais, über das die jeweilige Ansteuerung des zugehörigen elektrischen Verbrauchers erfolgt.

Nachteilig dabei ist, daß das Bordnetz eines Kraftfahrzeuges auf unterschiedlichen elektrischen Leistungsebenen arbeitet, die innerhalb der Zentralelektrik auf engstem Raum verarbeitet werden müssen, was die Störungsempfindlichkeit der einzelnen elektrischen Bauteile erhöht.

Der Erfindung liegt somit die Aufgabe zugrunde, eine kompakte und störungsunempfindliche Zentralelektrik für Kraftfahrzeuge anzugeben.

Erfindungsgemäß wird die Aufgabe dadurch gelöst, daß an der dem Bauteil abgewandten Seite des Bauteileträgers mindestens ein mit einer höheren Leistung beanspruchter Anschluß des elektrischen Bauteils mit einer Stromzufuhr kontaktiert ist, während mindestens ein niedrigbelasteter Anschluß des elektrischen Bauteils mit einem elektronische Bauelemente tragenden, von dem isolierenden Bauteileträger körperlich getrennt angeordneten Trägerkörper verbunden ist.

Der Vorteil der Erfindung besteht darin, daß durch die räumlich unterschiedliche Kontaktierung und damit verbundene Entkopplung der verschiedenen elektrischen Leistungsebenen eine Erhöhung der Störsicherheit der elektrischen und elektronischen Bauteile gegeben ist.

Vorteilhafterweise ist der niedrigbelastete Anschluß des Bauteils über eine zweifach steckbare Kontaktiereinrichtung mit dem Trägerkörper verbunden.

In einer Ausgestaltung sind der isolierende Bauteileträger und der die elektronischen Bauelemente tragende Trägerkörper in unterschiedlichen räumlichen Ebenen mindestens teilweise überlappend angeordnet, wobei auf dem Trägerkörper zur Aufnahme des niedrigbelasteten Anschlusses des elektrischen Bauteils die zweiteilige Kontaktiereinrichtung angeordnet ist, die die Signalzufuhr vom elektrischen Bauteil zur elektronischen Schaltung ermöglicht.

Die stapelförmige Anordnung der beiden Bauteileträger ermöglicht somit einen kompakten Aufbau der Zentralelektrik.

Zur Erleichterung der Montage weist die Kontaktiereinrichtung einen zweiarmigen Federkontakt auf, in welchen die den Bauteileträger überragenden Anschlüsse des elektrischen Bauteils einklemmbar sind. Der Federkontakt ist dabei in ein auf dem Trägerkörper angeordnetes Kontaktmodul steckbar, der zwei gegeneinander vorgespannte Kontaktfedern enthält.

Die als Steckverbindung gestaltete Kontaktiereinrichtung gewährleistet eine einfachere Handhabung bei Montage und Reparatur, da z. B. der Trägerkörper aus dem Gehäuse entfernt und ausgetauscht werden kann, ohne daß die elektrischen Bauteile auf der Oberseite des Gehäuses entfernt werden müssen.

In einer Weiterbildung bildet der isolierende Bauteileträger das Oberteil eines Gehäuses, wobei die die elektronischen Bauteile tragende Leiterplatte in dieses Gehäuse einschiebbar ist. Das Gehäuse ist dabei kastenförmig ausgebildet, an dessen einer Seitenwand eine zweite Kontaktiereinrichtung zur Aufnahme des mit einer höheren Leistung beanspruchten Anschlusses des elektrischen Bauteils angeordnet ist.

Im Herstellungsprozeß kann somit die Bestückung des Bauteileträgers erfolgen, bevor das Elektronikmodul in das Gehäuse eingeführt wird.

Weitere Ausgestaltungen der Erfindung sind in den Unteransprüchen gekennzeichnet.

Die Erfindung läßt zahlreiche Ausführungsformen zu. Eine davon soll anhand der in der Zeichnung dargestellten Figuren näher erläutert werden.

Es zeigt:

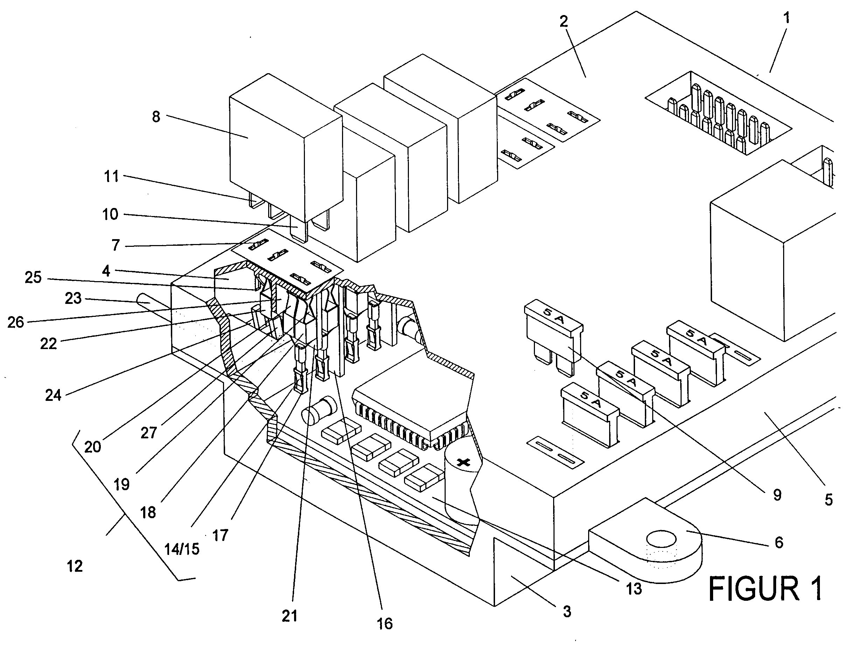

- Figur 1:: erfindungsgemäße Zentralelektrik für Kraftfahrzeuge
- Figur 2:: Kontaktiereinrichtung

Die erfindungsgemäße Zentralelektrik besteht aus einem kastenförmigen, aus isolierendem Material gefertigten Gehäuse 1, welches ein Oberteil 2, eine Abdeckplatte 3 sowie zwei Seitenwände 4 und 5 aufweist. Das Oberteil 2 und die zwei Seitenwände 4 und 5 können dabei wannenförmig miteinander verbunden sein. Die Abdeckplatte 3 besitzt mehrere, mit einer Bohrung versehene Anschlußstege 6, mit welchen die Zentralelektrik im Kraftfahrzeugmotorraum befestigt, vorzugsweise angeschraubt wird.

Das Oberteil 2 des Gehäuses 1 weist zahlreiche Steckerbuchsen 7 auf, in welche Relais 8, Sicherungen 9 oder andere elektrische Bauelemente eingeführt werden.

Im weiteren wird nur auf die Kontaktierung eines Relais 8 eingegangen. Eine analoge Kontaktierung anderer elektrischer Bauteile ist ebenfalls denkbar.

Ein Relais 8 weist unterschiedlich belastete Spulenanschlüsse (Steckerstift 10) und Schaltkontakte (Steckerstift 11) auf.

Die Steckerstifte 10 und 11 des Relais 8 werden dabei zur Kontaktierung in die Steckerbuchsen 7 des Oberteils 2 eingeführt und sind so dimensioniert, daß sie über das Oberteil 2 hinaus in das wannenförmige Gehäuse hineinragen.

Um nun eine Zentralelektrik mit diesen unterschiedlichen elektrischen Leistungsebenen kompakt aber trotzdem mit einem geringen Montageaufwand realisieren zu können, ist der mit einer niedrigeren Leistung belastete Steckerstift 10 des Relais 8 über eine erste zweifach gesteckte Kontaktiereinrichtung 12 mit einer Leiterplatte 13 verbunden, die eine elektronische Steuerschaltung, z. B. zur Ansteuerung von Scheibenwischermotoren, trägt.

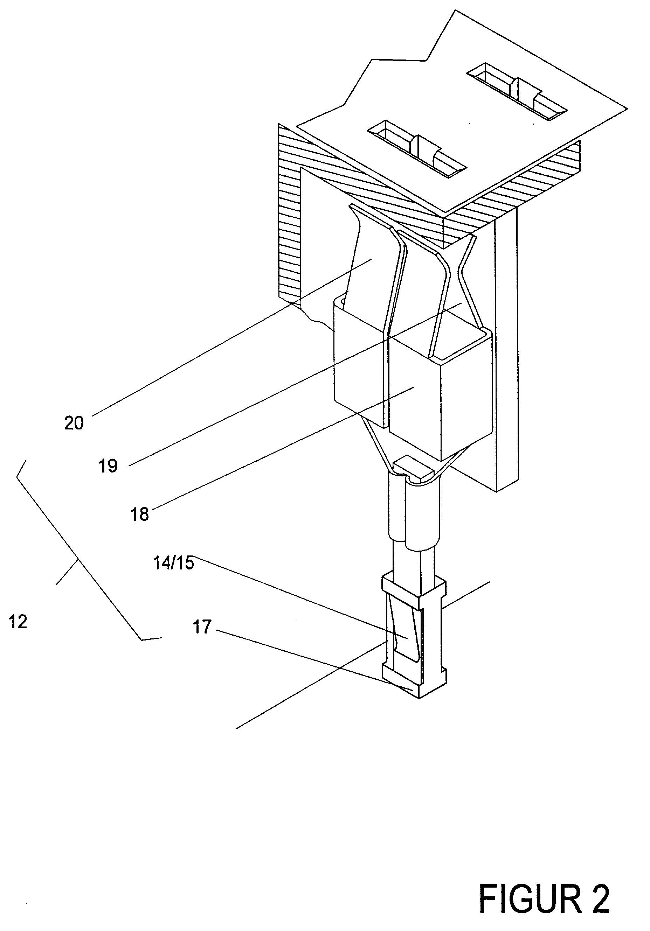

Die erste Kontaktiereinrichtung 12 (Figur 2) ist dabei elektrisch mit nicht weiter dargestellten Leitbahnen verbunden, die auf der Leiterplatte 13 aufgetragen sind. Somit wird der Schaltkontakt 10 des Relais 8 mit der einen Schwachstromkreis darstellenden elektronischen Steuerschaltung realisiert und die Signalzufuhr gewährleistet.

Die Kontaktiereinrichtung 12 selbst besteht dabei aus einem Kontaktmodul 17, das direkt auf der Leiterplatte 13 befestigt ist. Das Kontaktmodul 17 enthält zwei gegenüberliegende gegeneinander vorgespannte Kontaktfedern 14 und 15, in die ein metallischer Federkontakt 18 geklemmt ist. Dieser metallische Federkontakt 18 seinerseits besteht aus einem Stift, an welchem zwei identische Federpaare angeordnet sind, die dem Steckerstift 10 zugewandt sind. Jedes Federpaar weist zwei gegeneinander vorgespannte Teile 19 und 20 auf. In die beiden Federpaare wird der Steckerstift 10 des Relais 8 eingeführt und kontaktiert. Die Federpaare und der Stift bilden entweder ein Teil oder der Stift ist an die Federpaare angecrimt, wobei der Stift des Federkontaktes 18 in das Kontaktmodul 17 eingreift. Um eine sichere Montage des Steckerstiftes 10 mit dem Federkontakt 18 zu gewährleisten, ist eine senkrecht zum Oberteil 2 gebildete Zwischenwand 21 vorgesehen, die mit einer die Leiterplatte 13 tragenden Zwischenwand 16 die Kontaktarme 19 und 20 des Federkontaktes 18 positioniert.

Bei der Montage der Zentralelektrik wird die Leiterplatte 13 auf die Kontaktiereinrichtung 12 gesteckt und von der Gehäuseseitenwand 5 sowie der senkrecht zum Gehäuseoberteil 2 angeordneten Zwischenwand 16 an deren freiem Ende getragen.

Eine gleichgestaltete Kontaktvorrichtung 22 nimmt den mit einer höheren Leistung belasteten Steckerstift 11 des Relais 8 auf, welche den Steckerstift 11 mit einer elektrischen Leitung 23 des Kabelbaums des Kraftfahrzeugs zur Stromzufuhr verbindet. Diese Leitung 23 wird durch eine in der Abdeckplatte 3 befindliche Gehäuseöffnung 24 in die Zentralelektrik eingeführt. Zur Halterung der Kontaktiereinrichtung 22, insbesondere deren Kontaktmoduls, weist die Seitenwand 4 des Gehäuses 1 einen Seitensteg 25 auf. Außerdem ist eine senkrechte, vom Oberteil 2 bis zur Abdeckplatte 3 durchgängige Zwischenwand 26 vorgesehen. Die Kontaktiereinrichtung 22 ist dabei zwischen der Seitenwand 4 und der Zwischenwand 26 geführt.

Eine an der Kontaktiereinrichtung 22 befestigte, aber nicht weiter dargestellte Rastnase dient zur Befestigung der Kontaktiereinrichtung 22 am Seitensteg 25. Zur Zugentlastung der Kontaktiereinrichtung 22 ist eine Auszugssicherung 27 vorgesehen. Diese Auszugssicherung 27 ist als Steg ausgebildet und drückt ausgehend von der Abdeckplatte 3 von unten gegen die zweite Kontaktiereinrichtung 22.

In einer anderen Ausgestaltung ist die die elektronische Schaltung enthaltende Leiterplatte 13 in einem nicht weiter dargestellten Gehäuse angeordnet. An diesem Gehäuse ist das Kontaktmodul 17 der Kontaktiereinrichtung 12 befestigt, mittels welcher der niedrigbelastete Anschluß 10 des elektrischen Bauteils 8, wie zuvor beschrieben, mit der Leiterplatte 13 kontaktiert wird.

## Patentansprüche

1. Zentralelektrik für Kraftfahrzeuge, bei welchem ein elektrisches Bauteil, über das verschiedene elektrische Leistungsebenen miteinander verbunden werden, auf einem isolierenden Bauteileträger angeordnet ist, wobei die Anschlüsse des elektrischen Bauteils in den isolierenden Bauteileträger eingreifen, dadurch gekennzeichnet, daß an der dem Bauteil (8) abgewandten Seite des Bauteileträgers (2) mindestens ein mit einer höheren Leistung beanspruchter Anschluß (11) des elektrischen Bauteils (8) mit einer Stromzufuhr (23) kontaktiert ist, während mindestens ein niedrigbelasteter Anschluß (10) des elektrischen Bauteils (8) mit einem elektronische Bauelemente tragenden, von dem isolierenden Bauteileträger (2) körperlich getrennt angeordneten Trägerkörper (13) verbunden ist.

2. Zentralelektrik nach Anspruch 1, dadurch gekennzeichnet, daß der niedrigbelastete Anschluß (10) des Bauteils (8) über eine zweifach steckbare Kontaktiereinrichtung (12) mit dem Trägerkörper (13) verbunden ist.

3. Zentralelektrik nach Anspruch 2, dadurch gekennzeichnet, daß der isolierende Bauteileträger (2) und der die elektronischen Bauelemente tragende Trägerkörper (13) in unterschiedlichen räumlichen Ebenen zumindest teilweise überlappend angeordnet sind, wobei auf dem Trägerkörper (13) zur Aufnahme des niedrigbelasteten Anschlusses (10) des elektrischen Bauteils (8) die zweiteilige Kontaktiereinrichtung (12) angeordnet ist, die die Signalzufuhr vom elektrischen Bauteil (8) zur elektronischen Schaltung ermöglicht.

4. Zentralelektrik nach Anspruch 3, dadurch gekennzeichnet, daß die zweiteilige Kontaktiereinrichtung (12) einen zweiarmigen Federkontakt (18, 19, 20) aufweist, in welchem die den Bauteileträger (2) überragenden Anschlüsse (10) des elektrischen Bauteils (8) einklemmbar sind, und der Federkontakt (18, 19, 20) in ein auf dem Trägerkörper (13) angeordnetes Kontaktmodul (17) steckbar ist, der zwei gegeneinander vorgespannte Kontaktfedern (14, 15) enthält.

5. Zentralelektrik nach einem der vorhergehenden Ansprüche, dadurch gekennzeichnet, daß der isolierende Bauteileträger (2) das Oberteil eines Gehäuses (1) bildet und der die elektronischen Bauteile tragende Trägerkörper (13) in das Gehäuse einsteckbar ist.

6. Zentralelektrik nach Anspruch 5, dadurch gekennzeichnet, daß das Gehäuse (1) kastenförmig ausgebildet ist, an dessen einer Seitenwand (4) eine zweite Kontaktiereinrichtung (22) zur Aufnahme des mit einer höheren Leistung beanspruchten Anschlusses (11) des elektrischen Bauteils (8) angeordnet ist.

7. Zentralelektrik nach Anspruch 6, dadurch gekennzeichnet, daß die zweite Kontaktiereinrichtung (22) ein zweiarmiger Federkontakt ist, welcher den elektrischen Anschluß (10) des elektrischen Bauteils (8) mit der elektrischen Leitung (23) verbindet.

8. Zentralelektrik nach Anspruch 7, dadurch gekennzeichnet, daß die zweite Kontaktiereinrichtung (22) mit Hilfe eines Seitensteges (25) der Gehäuseseitenwand (4) und einer senkrecht zum Bauteileträger (2) angeordneten Zwischenwand (26) befestigt ist.

9. Zentralelektrik nach Anspruch 8, dadurch gekennzeichnet, daß die zweite Kontaktiereinrichtung (22) durch eine Auszugssicherung (27) gehalten wird, welche ausgehend von einer Abdeckplatte (3) des Gehäuses (1) gegen die Kontaktiereinrichtung (22) geführt wird.

10. Zentralelektrik nach einem der Ansprüche 1 bis 5, dadurch gekennzeichnet, daß der Trägerkörper (13) eine Leiterplatte ist.

11. Zentralelektrik nach einem der Ansprüche 1 bis 5, dadurch gekennzeichnet, daß der Trägerkörper (13) ein Gehäuse ist, in welchem die elektronischen Bauelemente angeordnet sind.
